# EUROPÄISCHE PATENTSCHRIFT

(11) **EP 2 821 741 B1**
(45) Veröffentlichungstag und Bekanntmachung des Hinweises auf die Patenterteilung: **27.04.2016**
(21) Anmeldenummer: 14174819.4
(22) Anmeldetag: 27.06.2014
(51) Int. Cl.: F25D 19/00, F25D 17/00

(54) **Verfahren zum Umrüsten einer Kryostatanordnung auf Umlaufkühlung**
Method for retrofitting a cryostat assembly for circulation cooling
Procédé de rééquipement d'un ensemble cryostat pour refroidissement par circulation

(30) Priorität: 03.07.2013 DE 102013213020
(43) Veröffentlichungstag der Anmeldung: 07.01.2015
(73) Patentinhaber: Bruker BioSpin AG, 8117 Fällanden (CH)
(72) Erfinder: Kraus, Andreas, 8616 Riedikon (CH); Schauwecker, Robert, 8004 Zürich (CH); Hinderer, Jörg, 79761 Waldshut-Tiengen (DE)
(74) Vertreter: Kohler Schmid Möbus Patentanwälte

(56) Entgegenhaltungen:
- EP-A2- 1 574 777
- DE-C1- 4 017 213
- US-A1- 2006 097 146
- US-A1- 2006 130 493
- US-A1- 2009 301 129
- US-A1- 2012 242 335
- US-B1- 6 181 228

## Beschreibung

Die Erfindung betrifft ein Verfahren zum Umrüsten einer Kryostatanordnung, die einen Raumtemperatur-Vakuumbehälter aufweist, in welchem ein erster Behälter mit einem Flüssig-Helium-Bad angeordnet ist, dessen Betriebstemperatur durch Helium-Verdampfung unter 5 K gehalten wird, wobei in dem Raumtemperatur-Vakuumbehälter außerdem ein zweiter Behälter, in welchen Kühlmittelleitungen hinein führen, angeordnet ist, welcher zum thermischen Abschirmen des ersten Behälters mit Flüssigstickstoff befüllt und durch Stickstoff-Verdampfung auf einer Betriebstemperatur von 75 bis 80 K gehalten werden kann.

Der Aufbau und das Einsatzgebiet einer solchen Anordnung, bei der beide Behälter wiederum innerhalb eines Raumtemperatur-Vakuumbehälters angeordnet sind, ist beispielsweise aus der US 4,510,771 A (=Referenz [0]) bekannt.

Auch die US-A 5,267,445 (=Referenz [1]) beschreibt eine ähnliche Anordnung.

### Hintergrund der Erfindung

Eine derartige Kryostatenanordnung wird insbesondere für die Kühlung supraleitender Magnetspulen verwendet. Solche Magnetspulen werden unter anderem für NMR (=Kernspinresonanz)-Messungen benötigt. Die NMR-Spektroskopie stellt ein leistungsfähiges Verfahren der instrumentellen Analytik dar. Dabei werden in eine Messprobe, die sich in einem starken, statischen Magnetfeld befindet, HF (=Hochfrequenz)-Pulse eingestrahlt, und die HF-Reaktion der Messprobe wird vermessen. Die relevanten Informationen werden integral über einen gewissen Bereich der Messprobe, das so genannte aktive Volumen, gewonnen.

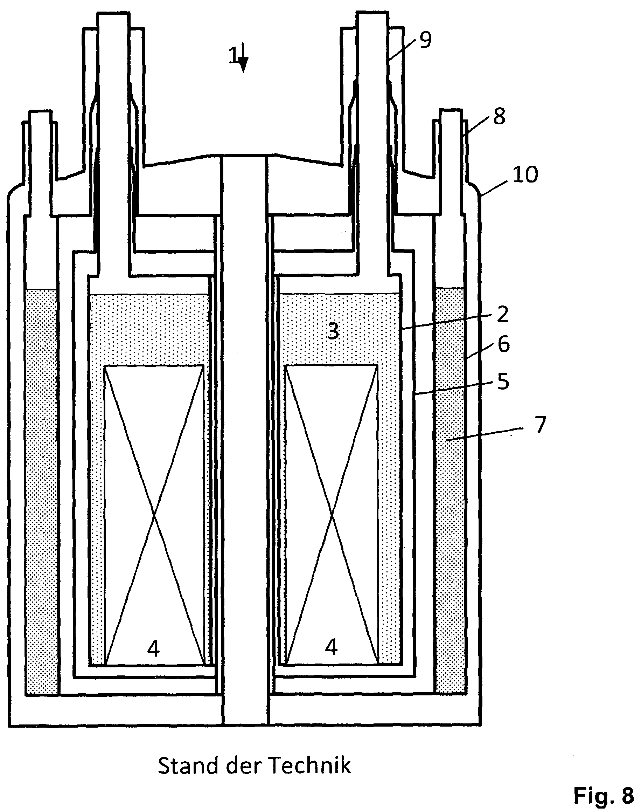

Zur Erzeugung der dafür benötigten hohen Magnetfelder werden supraleitende Magnetspulen verwendet, welche vorzugsweise in flüssigem Helium betrieben werden. Die Magnetspule und das flüssige Helium sind in einem ersten Behälter untergebracht. Die Temperatur dieses Behälters bleibt durch fortlaufendes Verdampfen des Heliums konstant. Um diesen Behälter können zusätzlich ein oder mehrere Strahlungsschilde angeordnet sein. Zwischen diesen Strahlungsschilden und dem äußeren Raumtemperatur-Vakuumbehälter ist ein ringförmiger zweiter Behälter angeordnet, welcher mit flüssigem Stickstoff befüllt ist und dessen Temperatur durch fortlaufendes Verdampfen des Stickstoffs konstant bei ca. 77 K gehalten wird. Eine solche Anordnung ist in Figur 8 gezeigt. Durch diesen Aufbau wird erreicht, dass der durch Strahlungswärme verursachte Wärmeeintrag in den ersten Behälter minimiert wird und damit insbesondere die Verdampfungsrate des Heliums im ersten Behälter so klein gehalten werden kann, dass typischerweise nur alle paar Monate Helium nachgefüllt werden muss.

Die passive Kühlung durch die verdampfenden Kryogene Helium und Stickstoff führt folglich dazu, dass in gewissen Zeitabständen immer wieder flüssiges Helium und Stickstoff nachgefüllt werden müssen. Der flüssige Stickstoff muss in deutlich geringeren Zeitabständen von ein bis zwei Wochen nachgefüllt werden.

Ein wesentlicher Nachteil dieser Anordnung liegt darin, dass die Handhabung der verwendeten Kryogene nicht ganz einfach ist und daher speziell ausgebildetes Personal erfordert. Durch das Nachfüllen entsteht außerdem eine in der Regel unerwünschte Unterbrechung der Messungen in der gekühlten Apparatur. Zudem ist die Abhängigkeit von der Versorgung mit flüssigen Kryogenen vor allem dort problematisch, wo keine optimale Infrastruktur hierfür vorhanden ist, wie z.B, in Schwellenländern (etwa Indien, afrikanische Länder, etc.). Auch eine zukünftige Verteuerung oder Verknappung der Kryogene macht eine solche Art der Kühlung recht kostspielig.

Mit der Verfügbarkeit mechanischer Refrigeratoren, welche Temperaturen unterhalb 4 K erreichen können, wurden weitere Kühlmöglichkeiten entwickelt, um die Abhängigkeit von flüssigem Helium und flüssigem Stickstoff zu verringern. Neben der Kühlung ausschließlich durch das Zuführen von Kryogenen gehören auch folgende Kühlvarianten zum Stand der Technik:
- Kühlkreisläufe mit gasförmigem Helium für Vorkühlung oder Betrieb von supraleitenden Magneten (siehe zum Beispiel in US 2007245749 A1, EP 0 398 156 B1, WO 95 01 539 A1)
- Kühlkreisläufe zur Kühlung von Strahlungsschilden oder Rückverflüssigung von Stickstoffgas (beispielsweise in EP 1 655 616 B1)
- Einbauvarianten von Kryokühlern in supraleitende Magnetsysteme für die Rückverflüssigung der Kryogene oder zur Kühlung von Strahlungsschilden (beschrieben in EP 0 905 436 B1, US 5,563,566 A1 oder US 5,613,367 A1)
- Externe Rückverflüssigung der Kryogene (z.B. in EP 1 628 089 A3)

### Nachteile des Standes der Technik

Die oben beschriebenen bekannten Anordnungen zur Vermeidung oder Verringerung des Verbrauchs von flüssigen Kryogenen gehen allesamt davon aus, dass der Kühlkreislauf entweder temporär für das Abkühlen besteht oder aber von Beginn an fest am System installiert ist. Anordnungen für den nachträglichen Einbau (etwa in EP 1 655 616 B1, EP 1 628 089 A3) zielen auf eine Rückverflüssigung der abdampfenden Kryogene und damit auf ein verlustfreies System.

Diese externe Rückverflüssigung des abdampfenden Heliums und Stickstoffs weist den Nachteil auf, dass die Kühlvorrichtung räumlich oberhalb der Kryostatenanordnung platziert werden muss und höhere Anforderungen an die Raumhöhe stellt, was in vielen Laboratorien problematisch ist. Experimente zur Messung der Magnetresonanz erfordern beispielsweise eine außerordentlich vibrationsarme Umgebung. Durch die Nähe der Kühleinrichtung zur Kryostatenanordnung wird die Dämpfung von im Betrieb entstehenden Vibrationen entsprechend schwierig.

Alternativ könnte man auch die abdampfenden Kryogene außerhalb der Kryostatenanordnung sammeln und mit einem separaten Kryosystem wieder verflüssigen. Ein solches System wird beispielsweise von der Firma Cryomech angeboten ("Liquid Helium Plants"), hat aber die Nachteile, dass ausschließlich Helium verflüssigt wird und dieses in relativ kurzen Abständen wieder in die Kryostatenanordnung zurücktransferiert werden muss.

### Aufgabe der Erfindung

Im Sinne eines Retrofits für bestehende Kryostatenanordnungen, welche beispielsweise zur Kühlung einer supraleitenden Spule sowohl flüssiges Helium als auch flüssigen Stickstoff verwenden, wäre es demgegenüber vorteilhaft, die Verwendung von flüssigem Stickstoff mit einem nachrüstbaren System gänzlich zu vermeiden und darüber hinaus noch die Abdampfrate des flüssigen Heliums deutlich zu verringern, ohne die verwendeten Kryogene rückverflüssigen zu müssen.

Der vorliegenden Erfindung liegt daher die Aufgabe zugrunde, ein Verfahren zum Umrüsten einer Kryostatanordnung mit den eingangs definierten Merkmalen mit möglichst einfachen technischen Maßnahmen so zu gestalten, dass die oben aufgezählten Nachteile des Standes der Technik weitestgehend vermieden werden, wobei zumindest kein flüssiger Stickstoff mehr eingesetzt werden muss. Eine weitere Aufgabe der vorliegenden Erfindung besteht darin, den Heliumverbrauch der Kryostatanordnung wesentlich herabzusetzen und außerdem auch noch einen über eine lange Zeitdauer ununterbrochenen Betrieb mit nur minimalen mechanischen Störungen zu ermöglichen.

### Kurze Beschreibung der Erfindung

Diese komplexe Aufgabe wird auf ebenso überraschend einfache wie wirkungsvolle Weise dadurch gelöst, dass bei einer gattungsgemäßen Kryostatanordnung mit den eingangs definierten Merkmalen ein fluides Kühlmedium, welches bei einer Temperatur von 60K und einem Druck von 1 bar gasförmig ist und einen wesentlich geringeren Siedepunkt als Stickstoff aufweist, in den zweiten Behälter eingebracht wird, und dass das Kühlmedium durch einen Refrigerator mittels eines Kühlkreislaufes, dessen Kühlmittelleitungen in den zweiten Behälter hinein führen, in gasförmigem Zustand auf eine Betriebstemperatur von ≤ 60 K gekühlt wird.

### Vorteile gegenüber dem Stand der Technik

Erfindungsgemäß wird die ursprüngliche bestimmungsgemäße Funktion des zweiten Behälters dahingehend verändert, dass kein flüssiger Stickstoff mehr verwendet wird und der Behälter stattdessen durch ein anderes Kühlmedium mit tieferem Siedepunkt auf eine Temperatur unter 60 K gekühlt werden kann, was mit Stickstoff keinesfalls erreichbar ist, da dieser bereits bei 63 K gefriert.

Zur Aufrechterhaltung der niedrigen Temperatur des Kühlmediums wird dieses über einen geschlossenen Kühlkreislauf mittels eines externen Refrigerators gekühlt. Die Kühlmittelleitungen des Kühlreislaufs sind mit den Ausgängen des zweiten Behälters verbunden, durch welche normalerweise bei bekannten Kryostatanordnungen nach dem Stand der Technik Stickstoffgas nach außen abströmt. Refrigeratoren, welche die erforderlichen Kühlleistungen und Temperaturen unterhalb 60 K erreichen, sind kommerziell erhältlich. Beispielsweise können als Refrigeratoren etwa Pulsrohr-, Gifford-McMahon- oder Stirling-Kühler eingesetzt werden. Allerdings ist bislang von der einschlägigen Fachwelt nie erwogen worden, derartige Refrigeratoren in einem geschlossenen Kühlkreislauf zur Kühlung des Kryogens (bisher immer Stickstoff) im *zweiten* Behälter zu benutzen, sondern ausschließlich *nur zur Kühlung beziehungsweise zur Rückverflüssigung des Heliums im ersten Behälter.*

Die Abdampfrate von flüssigem Helium im ersten Behälter wird maßgeblich bestimmt durch den Wärmeeintrag in Form von Wärmestrahlung und Wärmeleitung zwischen dem ersten Behälter und dem darum herum angeordneten zweiten Behälter. Dieser befindet sich normalerweise auf einer konstanten Temperatur, welche - bisher - durch den Siedepunkt des Stickstoffs bestimmt war, welcher bei einem Druck von 1 bar bei ca. 77K liegt.

Eine Möglichkeit zur Verringerung der Abdampfrate von flüssigem Helium aus dem ersten Behälter ergibt sich daher sehr einfach durch die Verringerung der Temperatur des zweiten Behälters (gegenüber dem bisher üblichen Temperaturniveau von flüssigem Stickstoff). Durch die Umrüstung des zweiten Behälters auf eine Kühlung durch ein anderes Kühlfluid mit wesentlich geringerem Siedepunkt im Vergleich zu Stickstoff, kann die Abdampfrate von Helium aus dem ersten Behälter auf wesentlich tiefere Werte (beispielsweise 50% des Normalwertes) verringert werden, da das Kühlmedium auch in gasförmigem Zustand einen sehr guten thermischen Kontakt zum zweiten Behälter hat, der zweite Behälter somit die Temperatur des Kühlmediums annimmt.

Damit können auf verblüffend einfache Weise zwei wesentliche Vorteile erzielt werden, indem erstens der Gebrauch von flüssigem Stickstoff vollständig vermieden wird und zweitens die Abdampfrate von flüssigem Helium auf tiefere Werte gebracht und damit der Heliumverbrauch ganz entscheidend verringert werden kann.

Die tiefere Abdampfrate von Helium hat zudem den großen Vorteil, dass weniger häufig und nur in zeitlich größeren Abständen Helium nachgefüllt werden muss. Auf diese Weise sind dann Haltezeiten von über einem Jahr leicht erreichbar. Dies ist vor allem in solchen Ländern von großem Vorteil, in denen die Beschaffung von flüssigem Helium nur in großen Zeitabständen möglich und der Preis desselben besonders hoch ist.

Das erfindungsgemäße System hat weiterhin den Vorteil, dass es nur durch flexible vakuumisolierte Kühlmittelleitungen mit dem zweiten Behälter der Kryostatanordnung verbunden ist. Daher kann der Refrigerator frei neben derselben platziert werden, ohne Einschränkungen bezüglich Raumhöhe und mit nur geringem Platzbedarf.

Ein weiterer Vorteil ergibt sich durch die Vibrationsentkopplung zwischen dem externen Refrigerator und der Kryostatenanordnung, welche nur durch die flexiblen vakuumisolierten Kühlmittelleitungen verbunden sind. Dadurch können beispielsweise Refrigeratoren eingesetzt werden, welche ein höheres Vibrationsniveau aufweisen, aber thermodynamisch effizienter sind, das heißt mit gleicher elektrischer Leistung eine höhere Kühlleistung erzielen. Außerdem sind derartige Refrigeratoren meistens auch noch deutlich preisgünstiger und bezüglich ihrer Dauerhaltbarkeit robuster.

Da der Kühlkreislauf geschlossen ist, muss während des Betriebs kein Kühlmittel nachgefüllt bzw. ersetzt werden. Durch die weitgehend freie Wahl des Refrigerators können kundenspezifisch unterschiedliche Kühlleistungen gewählt werden. Dies erlaubt es, das Füllintervall für das Nachfüllen von flüssigem Helium in den ersten Behälter in einem weiten Bereich zu varieren und beispielsweise mit den Serviceintervallen für den Refrigerator zusammenzulegen.

In der eingangs zitierten US-A 4,510,771 führen zwar Kühlmittelleitungen in den zweiten Behälter. Dabei allerdings wird davon ausgegangen, dass der Behälter mit Flüssigkeit gefüllt ist.

Bei den etwa in DE 195 48 273 A1 oder DE 42 27 388 A1 beschriebenen Vorrichtungen kann der zweite Behälter auch mit einem anderen kryogenen Fluid als Stickstoff betrieben werden, wobei dieses Kühlfluid aber stets flüssig ist. In DE 42 27 388 A1 dient ein Pulsrohrkühler mittels mechanischer Ankoppelung der kalten Stufe der Kühlung des Stickstoffbehälters.

Die vorliegende Erfindung geht hingegen davon aus, dass sich das Kühlmedium im zweiten Behälter in der gasförmigen Phase befindet. Im Gegensatz dazu ist in allen Entgegenhaltungen der zu kühlende zweite Behälter immer mit einem flüssigen Kühlmedium gefüllt.

Es ist wohl schon so, dass auch gemäß dem Stand der Technik der üblicherweise im zweiten Behälter befindliche flüssige Stickstoff durch ein anderes flüssiges Kühlmedium ersetzt werden kann, um noch tiefere Temperaturen zu erreichen.

Der Austausch des flüssigen Kühlmediums durch ein gasförmiges ist aber keineswegs offensichtlich, da damit die physikalische Eigenschaft der Kühlung durch Verdampfen des Kühlmediums aufgegeben wird und das Kühlmedium - in der Regel durch einen externen Refrigerator - extra gekühlt werden muss. Vermeintlich scheint dies auf den ersten Blick ein Nachteil zu sein, da die positiven Eigenschaften eines flüssigen Mediums aufgegeben werden, nämlich die hohe Temperaturstabilität und die hohe Kühlleistung aufgrund der Verdampfungswärme des verdampfenden -zunächst flüssigen- Kühlmediums.

Durch ein - von vornherein - gasförmiges Fluid ist man aber im Endeffekt wesentlich variabler in der Temperaturwahl, was mit einer Flüssigkeit nur sehr eingeschränkt möglich ist, indem der Systemdruck geändert wird und man sich auf der Dampfdruckkurve bewegen muss. Ein Unterdruck zur Senkung der Temperatur ist aber in der Regel unerwünscht, da dies bei eindringender Luft schnell zu gefährlichen Vereisungen führen kann. Die Verwendung von flüssigem Neon oder Wasserstoff ist aus Kosten- und Sicherheitsüberlegungen eher theoretischer Natur, so dass eigentlich nur flüssiger Stickstoff bei solchen Geräten zum Einsatz kommt.

Das Ersetzen des flüssigen Stickstoffs im zweiten Behälter durch gasförmiges Fluid wie Helium oder Neon ist daher keine naheliegende Idee sondern beruht auf einer erfinderischen Tätigkeit.

Keiner der Vorschläge aus dem Stand der Technik vermag - jedenfalls nicht *ohne* die kennzeichnenden Merkmale des vorliegenden Patentanspruchs 1 - die im Wesentlichen bereits in der Beschreibung dargelegte, genau besehen doch relativ weitgehenden Vorteile der vorliegenden Erfindung zu erzielen:

### Bevorzugte Ausführungsformen der Erfindung

Bei bevorzugten Ausführungsformen des erfindungsgemäßen Verfahrens wird als fluides Kühlmedium gasförmiges Helium oder Neon verwendet. Diese beiden leichtesten Edelgase sind schon seit vielen Jahrzehnten in der Kryotechnik zur Erzeugung besonders tiefer Temperaturen im Gebrauch, weil sie bis zu tiefen Temperaturen unter Normalbedingungen gasförmig bleiben, während Stickstoff bereits bei 63 K gefriert. Insbesondere Helium kondensiert erst bei 4.2 K und Heliumgas ist in Form von Druckgasflaschen viel einfacher erhältlich als flüssiges Helium.

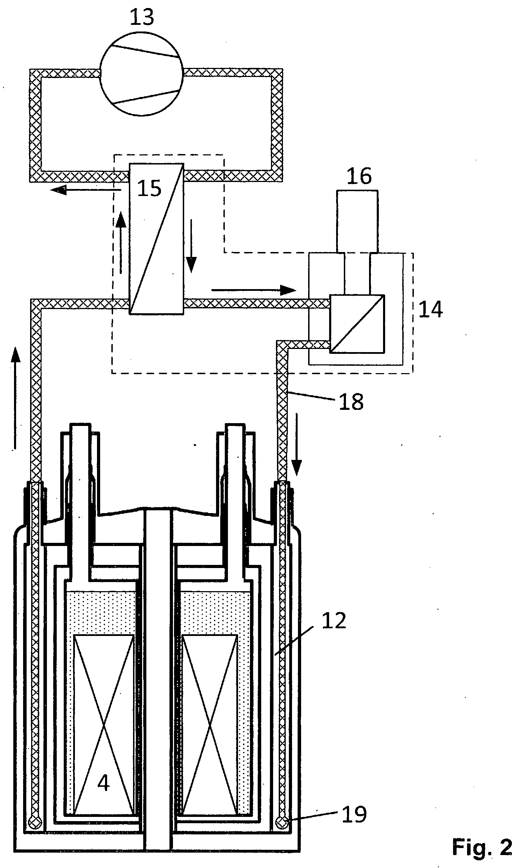

Vorteilhaft ist eine Klasse von Ausführungsformen des erfindungsgemäßen Verfahrens, bei der ein Wärmeaustauscher in dem zweiten Behälter angeordnet und an die Kühlmittelleitungen des Kühlkreislaufs angeschlossen und das Kühlmedium mittels des Wärmeaustauschers auf eine Betriebstemperatur von ≤ 60 K gekühlt wird. Vorteile und Wirkungsweise sind im Detail der Beschreibung zur Fig. 2 zu entnehmen.

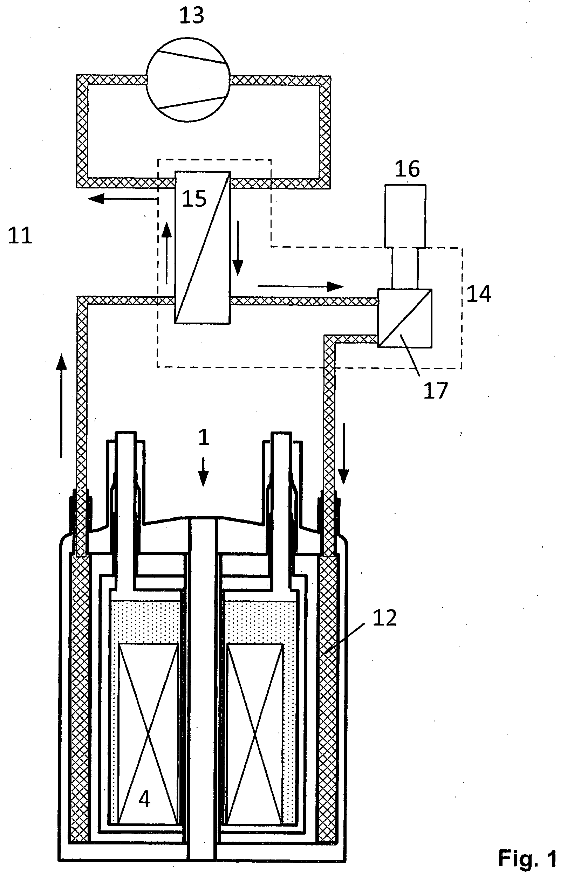

Besonders bevorzugt ist eine Klasse von dazu alternativen Ausführungsformen, bei welchen die Kühlmittelleitungen des Kühlkreislaufs innerhalb des zweiten Behälters offen sind, wobei das Kühlmedium aus dem zweiten Behälter in die Kühlmittelleitungen des Kühlkreislaufs geleitet und auf eine Betriebstemperatur von ≤ 60 K gekühlt wird. Vorteile und Wirkungsweise sind im Detail der Beschreibung zur Fig. 1 zu entnehmen.

Bei einer weiteren bevorzugten Variante des erfindungsgemäßen Verfahrens ist der zweite Behälter, der beim Umrüsten der Kryostatanordnung durch das eingebrachte gasförmige Kühlmedium ergänzt oder ausgetauscht wird, vor dem Umrüsten mit Flüssigstickstoff befüllt. In diesem Falle geschieht die Umrüstung bei einem System, welches schon in seiner ursprünglichen Konfiguration, d.h. mit verdampfendem Stickstoff im zweiten Behälter, in Betrieb ist und nun nach dem erfindungsgemäßen Verfahren umgerüstet wird. Dieses Verfahren ist deshalb vorteilhaft, weil auch alle bereits an Kunden ausgelieferte und in Betrieb befindliche Kryostatenanordnungen auf sehr unkomplizierte Weise umgerüstet werden können.

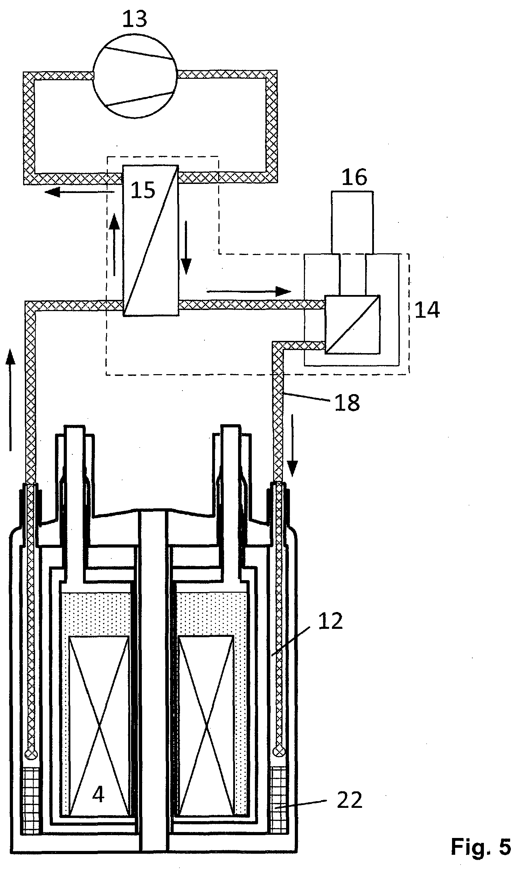

Vorteilhaft ist auch eine Verfahrensvariante, bei welcher im zweiten Behälter zusätzlich zum fluiden Kühlmedium eine Stickstoffmenge belassen und/oder eingebracht wird, welche bei einer Betriebstemperatur von ≤ 60 K ein Volumen von mindestens 5 I einnimmt. Vorteile und Wirkungsweise sind im Detail der Beschreibung zur Fig. 5 zu entnehmen.

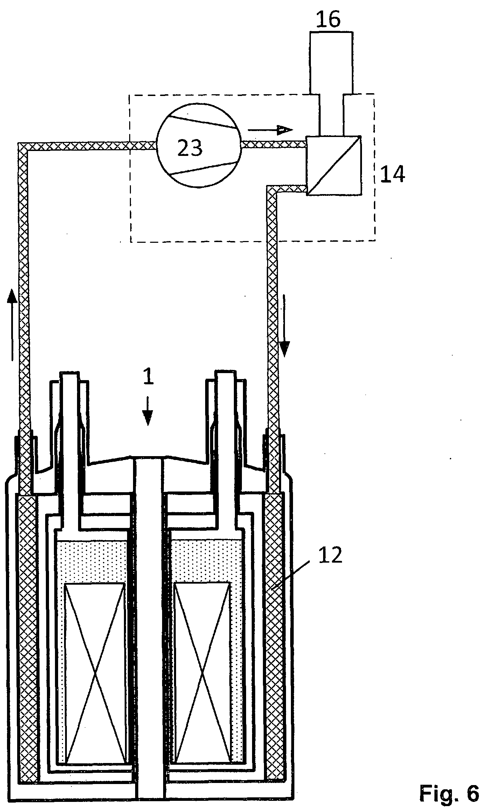

Weitere bevorzugte Ausführungsformen der Erfindung zeichnen sich dadurch aus, dass der Kühlkreislauf einen Verdichter aufweist, der als ein Kompressor des Refrigerators, als ein Kaltgasverdichter oder als eine bei Umgebungstemperatur betriebene Pumpe ausgestaltet ist, welche durch einen Gegenstrom-Wärmetauscher in den Kühlkreislauf integriert ist. Zur Kühlung des zweiten Behälters durch eine wärmeleitende Verbindung zum Kühlmedium und dem Kühlmittel muss dieses im Kühlkreislauf zirkulieren, da es sich innerhalb des zweiten Behälters erwärmt und am Refrigerator wieder abgekühlt werden muss. Um das Kühlmittel bei Raumtemperatur verdichten zu können, wird typischerweise ein Gegenstromwärmetauscher verwendet, wie er in der Wärme-und Kältetechnik vielfach Verwendung findet. Weitere Vorteile und Wirkungsweise bezüglich der Verwendung eines Kaltgasverdichters sind im Detail der Beschreibung zur Fig. 6 zu entnehmen.

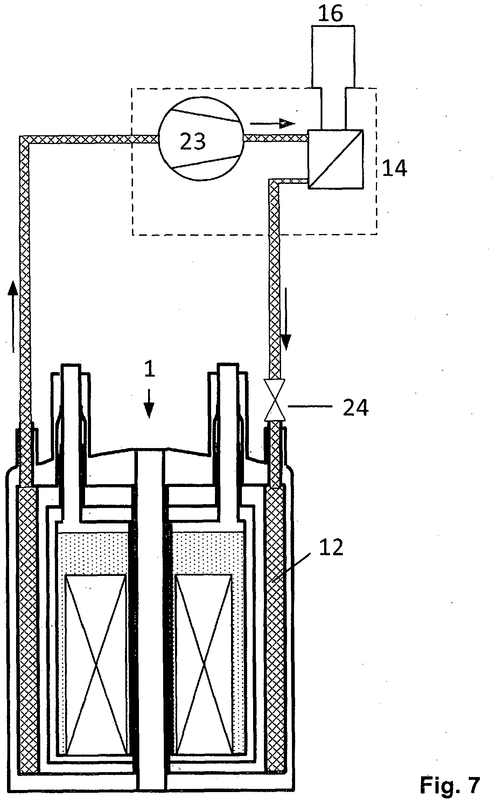

Besonders vorteilhaft ist auch eine Klasse von Ausführungsformen der erfindungsgemäßen Kryostatanordnung, die sich dadurch auszeichnen, dass der Kühlkreislauf eine Joule-Thomson-Expansionsstufe aufweist. Vorteile und Wirkungsweise sind im Detail der Beschreibung zur Fig. 7 zu entnehmen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine Ausführungsform der Kryostatanordnung in schematischem Vertikalschnitt, bei welcher das im Kühlkreislauf zirkulierende Kühlmittel identisch ist mit demjenigen im zweiten Behälter;
- Fig. 2: eine Ausführungsform wie in Fig. 1, jedoch mit anderem Kühlmedium im zweiten Behälter als im Kühlkreislauf;
- Fig. 3: eine Ausführungsform wie in Fig. 1, jedoch mit Elementen zur Dämpfung von Vibrationen an den Kühlmittelleitungen;
- Fig. 4: eine Ausführungsform wie in Fig. 3, jedoch zusätzlich mit einem Vorratsvolumen an Kühlmedium in einem an den Kühlmittelkreislauf angeschlossenen Kühlmediumtank;
- Fig. 5: eine Ausführungsform wie in Fig. 2, jedoch zusätzlich mit einem Restvolumen von bei der Umrüstung nicht vollständig entferntem flüssigem Stickstoff;
- Fig.6: eine Ausführungsform wie in Fig. 1, jedoch mit einem in die Coldbox integrierten Verdichter, welcher das Kühlmittel bei tiefer Temperatur verdichtet und die Verwendung eines Gegenstromwärmetauschers obsolet macht;
- Fig. 7: eine Ausführungsform wie in Fig. 6, jedoch zusätzlich mit einem Joule-Thomson-Ventil in der Kühlmittelleitung vor den Eintritt in den zweiten Behälter; und
- Fig. 8: eine Kryostatanordnung nach dem Stand der Technik.

Allgemein betrifft die vorliegende Erfindung ein Verfahren zum Umrüsten einer Kryostatanordnung, wie sie prinzipiell bereits aus dem Stand der Technik bekannt ist, der schematisch in Fig. 8 illustriert und oben ausführlich diskutiert wurde.

Die **Kryostatanordnung 1** weist einen **Raumtemperatur-Vakuumbehälter 10** auf, in welchem ein **erster Behälter 2** mit einem **Flüssig-Helium-Bad 3** angeordnet ist, dessen Betriebstemperatur durch Helium-Verdampfung bei unter 5 K gehalten wird, wobei in dem Raumtemperatur-Vakuumbehälter 10 außerdem ein **zweiter Behälter 6,** angeordnet ist, welcher zum thermischen Abschirmen des ersten Behälters 2 mit einem **Flüssig-Stickstoff-Bad 7** befüllt und durch Stickstoff-Verdampfung auf einer Betriebstemperatur von 75 bis 80 K gehalten werden kann.

Die in Fig. 8 gezeigte Kryostatanordnung 1 nach dem Stand der Technik - und ebenso auch die Anordnung der Figuren 1-7- werden typischerweise für NMR-Geräte verwendet. Der erste , mit flüssigem Helium 3 befüllte Behälter 2 der Anordnung 1 enthält eine in der Regel supraleitende **Magnetanordnung 4** und ist von einem **Strahlungsschild 5** umgeben, welches wiederum vom zweiten Behälter 6 umgeben ist, der flüssigen Stickstoff 7 enthält. Der Raumtemperatur-Vakuumbehälter 10 umschließt die beiden Behälter 2, 6 und den Strahlungsschild 5. Der erste Behälter 2 weist eine **Füllöffnung 9** und der zweite Behälter 6 weist eine **Füllöffnung 8** auf, durch welche jeweils einerseits die verdampfenden Kryogene entweichen können und welche andererseits für das Nachfüllen verwendet werden.

Die Helium Abdampfrate aus dem ersten Behälter 2 wird bestimmt durch den Wärmeeintrag von außen aufgrund von Strahlung und Wärmeleitung durch die Füllöffnungen 8, 9. Durch ein im äußeren Raumtemperatur-Behälter 10 herrschendes Vakuum und den beschriebenen zwiebelschalenartigen Aufbau der Anordnung 1 kann die Helium-Abdampfrate typischerweise in einem Bereich von ungefähr 100 ml/h gehalten werden.

Demgegenüber ist die vorliegende Erfindung dadurch gekennzeichnet, dass - im Zuge einer Um- beziehungsweise Nach-Rüstung einer Kryostatanordnung 1 gemäß dem Stand der Technik - ein **fluides Kühlmedium 12** in den zweiten Behälter 6 eingebracht wird, welches bei einer Temperatur von 60 K und einem Druck von 1 bar gasförmig ist, und dass das Kühlmedium 12 durch einen **Refrigerator 16** mittels eines **Kühlkreislaufes 11,** dessen Kühlmittelleitungen in den zweiten Behälter 6 hinein führen, auf eine Betriebstemperatur von ≤ 60 K gekühlt wird.

Fig.1 veranschaulicht schematisch eine Ausführungsform der Kryostatanordnung 1 mit dem Kühlkreislauf 11, welcher mit den Füllöffnungen des zweiten Behälters 6 verbunden ist. Im gezeigten Ausführungsbeispiel ist das Kühlmedium im zweiten Behälter 6 identisch mit dem Kühlmittel, welches im Kühlkreislauf 11 zirkuliert. Das Kühlmedium 12 wird von einem **Verdichter 13** über einen **Gegenstrom-Wärmetauscher 15** zu einem **zweiten Wärmetauscher 17** geleitet, welcher vom Refrigerator 16 gekühlt wird. Das Kühlmedium 12 fließt dann durch den zweiten Behälter 6 und kühlt diesen auf eine Temperatur von unter 60 K. Das aus dem zweiten Behälter 6 austretende Kühlmedium 12 fließt anschließend durch den Gegenstrom-Wärmetauscher 15 zurück zum Verdichter 13. Die Wärmetauscher 15, 17 und der Refrigerator 16 sind in eine geschlossene **Coldbox 14** eingebaut, welche unter Vakuum gehalten wird.

Fig. 2 zeigt eine ähnliche Ausführungsform wie Fig. 1, bei der jedoch das Kühlmedium 12 im zweiten Behälter 6 nicht dem **im Kühlkreislauf 11 zirkulierenden Kühlmittel 18** entspricht. Der Wärmeaustausch im zweiten Behälter 6 geschieht über die Oberfläche eines **Wärmeaustauschelementes 19.** Dieses Element kann beispielsweise in Form eines langen Schlauchs in den zweiten Behälter 6 eingeführt werden.

Dies hat den Vorteil, dass der Kühlkreislauf 11 vollständig dicht gegen die Kryostatenanordnung 1 ausgestaltet ist. Dadurch kann im Kühlkreislauf 11 ein anderes Kühlmittel 18 verwendet werden und der Arbeitsdruck des Kühlmittels 18 ist unabhängig vom Arbeitsdruck im zweiten Behälter 6. Da infolge einer entsprechenden mechanischen Auslegung des zweiten Behälters 6 nur ein geringer Überdruck gegen die Atmosphäre möglich ist, kann im Kühlkreislauf 11 ein viel höherer Druck gewählt werden, wodurch die Dichte des Kühlmittels 18 höher ist und die thermodynamische Effizienz des Kühlloops gesteigert werden kann.

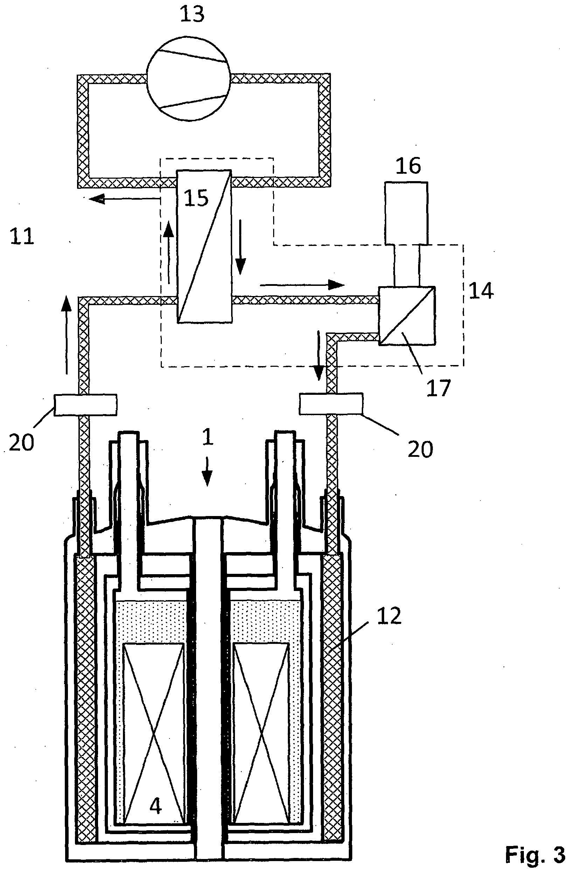

Die Kühlmittelleitungen können Vibrationen vom Verdichter 13 und Refrigerator 16 zur Kryostatenanordnung 1 leiten. Bei sehr sensitiven, insbesondere hochauflösenden spektroskopischen Messungen können diese Vibrationen zu nicht-akzeptablen Störungen im Messsignal führen. Gegenüber der Ausführungsform von Fig. 1 sind daher bei der in Fig. 3 gezeigten Anordnung die Kühlmittelleitungen mit **Dämpfungselementen 20** zur Dämpfung der Vibrationen mechanisch verbunden. Solche Dämpfungselemente können aktiver oder passiver Natur sein und beispielsweise aus einem massiven Metallfuß bestehen, mit dem die Kühlmittelleitung kraftschlüssig verbunden ist, um Vibrationen zu dämpfen.

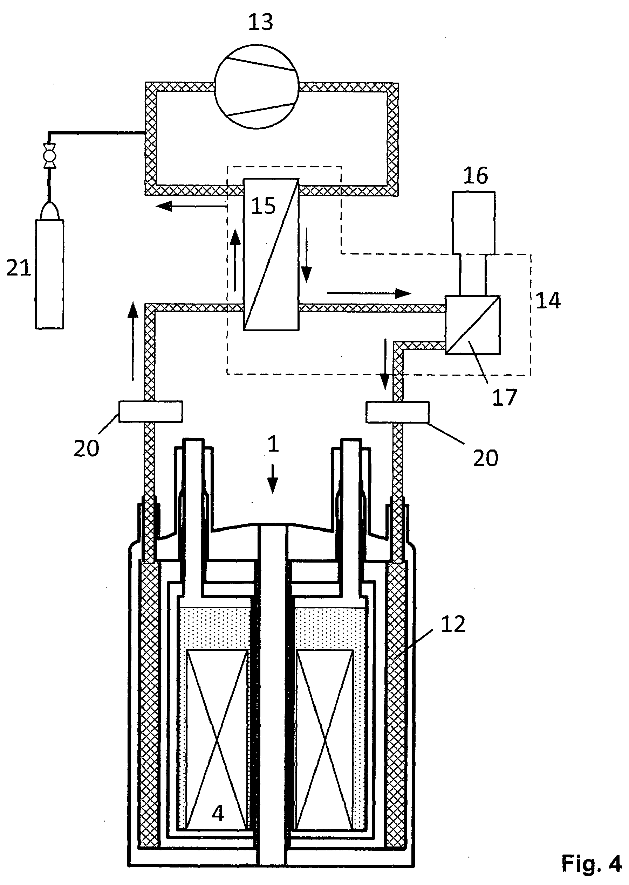

Zusätzlich zur Anordnung gemäß Fig. 3 ist bei der in Fig. 4 gezeigten Kryostatanordnung 1 ein **Kühlmedium-Tank 21** mit dem Kühlmittelkreislauf 11 verbunden. Der Kühlmediumtank 21 hat die Aufgabe, einen Vorrat an Kühlmedium 12 beziehungsweise 18 zu beherbergen und den Druck im Kühlkreislauf 11 möglichst konstant zu halten. Der Kühlmediumtank 21 kann beispielweise eine Druckflasche umfassen, welche über ein Druckreduzierventil mit dem Kühlmittelreislauf 11 verbunden wird.

Im Vergleich zur Anordnung gemäß Fig. 2 wurde bei der Anordnung nach Fig. 5 der für den bestimmungsgemäßen Gebrauch der Kryostatenanordnung 1 im zweiten Behälter 6 enthaltene flüssige Stickstoff 7 nicht vollständig entfernt, bevor der Kühlkreislauf 11 angeschlossen wurde. Da die Fluidräume von Kühlmittel 18 und Kühlmedium 12 nicht verbunden sind, wird dieser Stickstoff bei Temperaturen unterhalb ca. 63 K ausfrieren. Der Vorteil dieses **Stickstoffreservoirs 22** für eine Restmenge N2 zeigt sich in Fällen, wo der Kühlmittelkreislauf 11 - etwa auf Grund eines Stromausfalls oder Defektes am Refrigerator 16 oder am Verdichter 13 - nicht mehr voll funktionstüchtig ist. In diesen Fällen wird sich der zweite Behälter 6 aufwärmen, durch den darin enthaltenen Stickstoff aber dennoch immerhin auf einer Temperatur von ca.

77K gehalten werden, was den Betrieb der Kryostatenanordnung 1 über längere Zeit sichert.

Im Vergleich zur Anordnung nach Fig. 1 ist bei der in Fig. 6 gezeigten Kryostatanordnung 1 ein **Kaltgas-Verdichter 23** in die Coldbox 14 integriert und arbeitet bei der Temperatur des kalten Kühlmittels 12. Dies hat den Vorteil, dass das Kühlmittel 12 nicht in einem Gegenstromwärmetauscher erwärmt werden muss, bevor es zum Verdichter 23 gelangt. Solche Verdichter, die bei tiefen Temperaturen arbeiten, werden beispielsweise von der Firma Cryozone BV vertrieben. Durch diese Anordnung lässt sich der Wirkungsgrad des Kühlmittelkreislaufs 11 nochmals deutlich steigern und die Kosten dennoch senken, da ein Gegenstrom-Wärmetauscher entfällt.

Im Vergleich zu Anordnung gemäß Fig. 6 wird bei der in Fig. 7 dargestellten Kryostatanordnung 1 das Kühlmittel 12 beim Eintritt in den zweiten Behälter 6 über ein **Joule-Thomson-Expansions-Ventil 24** entspannt. Je nach Temperatur und Druck kann durch das Entspannen eines Gases die Temperatur sinken und somit ein zusätzlicher Kühleffekt erzielt werden. Dieser Effekt wird beispielsweise im altbekannten Linde-Verfahren zur Verflüssigung von Luft eingesetzt.

Diese zusätzliche Kühlung kann genützt werden, wenn der Verdichter 23 eine hohe Kompression des Kühlmittels 12 erzielt und für das Kühlmittel 12 ein geeignetes Gas wie beispielsweise Neon, verwendet wird. Damit können im zweiten Behälter 6 noch tiefere Temperaturen erreicht werden, was wiederum die Abdampfrate des Heliums aus dem ersten Behälter 2 weiter senkt.

Fig. 8 schließlich zeigt den oben bereits ausführlich beschriebenen Stand der Technik.

### Bezugszeichenliste:

- (1): Kryostatanordnung
- (2): Erster Behälter
- (3): Flüssig-Helium-Bad
- (4): Magnetanordnung
- (5): Strahlungsschild
- (6): Zweiter Behälter
- (7): Flüssig-Stickstoff-Bad
- (8): Füllöffnung zweiter Behälter
- (9): Füllöffnung erster Behälter
- (10): Raumtemperatur Vakuum Behälter
- (11): Kühlkreislauf
- (12): Kühlmedium
- (13): Verdichter
- (14): Coldbox
- (15): Gegenstrom Wärmetauscher
- (16): Refrigerator
- (17): Wärmetauscher
- (18): Kühlmittel im Kühlkreislauf
- (19): Wärmeaustauschelement
- (20): Dämpfungselement
- (21): Kühlmedium-Tank
- (22): Restmenge N2
- (23): Kaltgas-Verdichter für kaltes Kühlmittel
- (24): Joule-Thomson Expansionsventil

### Referenzliste

[0] US 4,510,771 A
[1] US-A 5,267,445
[2] US 2007245749 A1
[3] EP0398156 B1
[4] WO 95 01 539 A1
[5] EP 1 655 616 B1
[6] EP 0 905 436 B1
[7] US 5,563,566 A1
[8] US 5,613,367 A1
[9] EP 1 628 089 A3
[10] DE 195 48 273 A1
[11] DE 42 27 388 A1

## Patentansprüche

1. Verfahren zum Umrüsten einer Kryostatanordnung (1), die einen Raumtemperatur-Vakuumbehälter (10) aufweist, in welchem ein erster Behälter (2) mit einem Flüssig-Helium-Bad (3) angeordnet ist, dessen Betriebstemperatur durch Helium-Verdampfung unter 5 K gehalten wird, wobei in dem Raumtemperatur-Vakuumbehälter (10) außerdem ein zweiter Behälter (6), in welchen Kühlmittelleitungen hinein führen, angeordnet ist, welcher zum thermischen Abschirmen des ersten Behälters (2) mit Flüssigstickstoff (7) befüllt und durch Stickstoff-Verdampfung auf einer Betriebstemperatur von 75 bis 80 K gehalten werden kann, **dadurch gekennzeichnet,**
**dass** ein fluides Kühlmedium (12), welches bei einer Temperatur von 60 K und einem Druck von 1 bar gasförmig ist und einen wesentlich geringeren Siedepunkt als Stickstoff aufweist, in den zweiten Behälter (6) eingebracht wird, und dass das Kühlmedium (12) durch einen Refrigerator (16) mittels eines Kühlkreislaufes (11), dessen Kühlmittelleitungen in den zweiten Behälter (6) hinein führen, in gasförmigem Zustand auf eine Betriebstemperatur von ≤ 60 K gekühlt wird.

2. Verfahren nach Anspruch 1, **dadurch gekennzeichnet, dass** als fluides Kühlmedium (12) gasförmiges Helium oder Neon verwendet wird.

3. Verfahren nach Anspruch 1 oder 2, **dadurch gekennzeichnet, dass** ein Wärmeaustauscher (19) in dem zweiten Behälter (6) angeordnet und an die Kühlmittelleitungen des Kühlkreislaufs angeschlossen wird, und dass das Kühlmedium (12) mittels des Wärmeaustauschers (19) auf eine Betriebstemperatur von ≤ 60 K gekühlt wird.

4. Verfahren zum Umrüsten einer Kryostatanordnung (1) nach Anspruch 1 oder 2, **dadurch gekennzeichnet, dass** die Kühlmittelleitungen des Kühlkreislaufs (11) innerhalb des zweiten Behälters (6) offen sind, so dass das Kühlmedium (12) aus dem zweiten Behälter (6) in die Kühlmittelleitungen des Kühlkreislaufs (11) geleitet und auf eine Betriebstemperatur von ≤ 60 K gekühlt wird.

5. Verfahren nach einem der vorhergehenden Ansprüche, **dadurch gekennzeichnet, dass** der zweite Behälter (6) vor dem Umrüsten mit Flüssigstickstoff (7) befüllt ist, der beim Umrüsten der Kryostatanordnung (1) durch das eingebrachte gasförmige Kühlmedium (12) ergänzt oder ausgetauscht wird.

6. Verfahren nach einem der vorhergehenden Ansprüche, **dadurch gekennzeichnet, dass** im zweiten Behälter (6) zusätzlich zum fluiden Kühlmedium(12) eine Stickstoffmenge (22) belassen und/oder eingebracht wird, welche bei einer Betriebstemperatur von ≤ 60 K ein Volumen von mindestens 5 I einnimmt.

7. Verfahren nach einem der vorhergehenden Ansprüche, **dadurch gekennzeichnet, dass** die Kryostatanordnung Teil einer Kernspinresonanz-Apparatur ist und zur Kühlung einer supraleitenden Magnetanordnung (4) dient.

8. Verfahren nach einem der vorhergehenden Ansprüche, **dadurch gekennzeichnet, dass** in den Kühlmittelleitungen des Kühlkreislaufs (11) ein Dämpfungselement (20) zur Isolation von mechanischen Schwingungen integriert ist.

9. Verfahren nach einem der vorhergehenden Ansprüche, **dadurch gekennzeichnet, dass** die Kryostatanordnung einen außerhalb des Raumtemperatur-Vakuumbehälters (10) angeordneten Kühlmedium-Tank (21) aufweist, mittels dessen der zweite Behälter(6) und/oder der Kühlkreislauf (11) mit Kühlmedium (12) gespeist wird, um Druckschwankungen entgegenzuwirken.

10. Verfahren nach einem der vorhergehenden Ansprüche, **dadurch gekennzeichnet, dass** der Kühlkreislauf (11) einen Verdichter (13) aufweist, der als ein Kompressor des Refrigerators (16), als ein Kaltgas-Verdichter (23) oder als eine bei Umgebungstemperatur betriebene Pumpe ausgestaltet ist, welche durch einen Gegenstrom-Wärmetauscher (15) in den Kühlkreislauf (11) integriert ist.

11. Verfahren nach einem der vorhergehenden Ansprüche, **dadurch gekennzeichnet, dass** der Kühlkreislauf (11) eine Joule-Thomson-Expansionsstufe (24) aufweist.

## Claims

1. Method for converting a cryostat configuration (1) comprising a room temperature vacuum container (10) containing a first container (2) with a liquid helium bath (3), the operating temperature of which is kept below 5K by means of helium evaporation, wherein the room temperature vacuum container (10) additionally contains a second container (6) into which coolant lines are guided and which is filled with liquid nitrogen (7) for thermally shielding the first container (2) and can be kept at an operating temperature of between 75 and 80K by means of nitrogen evaporation, **characterized in that** a fluid cooling medium (12) is introduced into the second container (6) which is gaseous at a temperature of 60K and a pressure of 1 bar and has a substantially lower boiling point than nitrogen, and the cooling medium (12) is cooled in the gaseous state to an operating temperature of ≤60K by a refrigerator (16) by means of a cooling circuit (11), the coolant lines of which are guided into the second container (6).

2. Method according to claim 1, **characterized in that** helium or neon is used as fluid cooling medium (12).

3. Method according to claim 1 or 2, **characterized in that** a heat exchanger (19) is arranged in the second container (6) and is connected to the coolant lines of the cooling circuit, and the cooling medium (12) is cooled to an operating temperature of ≤60K by means of the heat exchanger (19).

4. Method for converting a cryostat configuration (1) according to claim 1 or 2, **characterized in that** the coolant lines of the cooling circuit (11) are open inside the second container (6) such that the cooling medium (12) is guided from the second container (6) into the coolant lines of the cooling circuit (11) and cooled to an operating temperature of ≤60K.

5. Method according to any one of the preceding claims, **characterized in that** prior to conversion, the second container (6) is filled with liquid nitrogen (7) which is supplemented or replaced by the introduced gaseous cooling medium (12) during conversion of the cryostat configuration (1).

6. Method according to any one of the preceding claims, **characterized in that** an amount of nitrogen (22) is left in and/or introduced into the second container (6) in addition to the fluid cooling medium (12), the nitrogen occupying a volume of at least 5 I at an operating temperature of ≤60K.

7. Method according to any one of the preceding claims, **characterized in that** the cryostat configuration is part of a nuclear magnetic resonance apparatus and is used to cool a superconducting magnet configuration (4).

8. Method according to any one of the preceding claims, **characterized in that** a damping element (20) is integrated
in the coolant lines of the cooling circuit (11) for insulating mechanical vibrations.

9. Method according to any one of the preceding claims, **characterized in that** the cryostat configuration has a cooling medium tank (21) that is arranged outside of the room temperature vacuum container (10) and by means of which the second container (6) and/or the cooling circuit (11) can be supplied with cooling medium (12) in order to counteract pressure fluctuations.

10. Method according to any one of the preceding claims, **characterized in that** the cooling circuit (11) has a compactor (13) which is designed as a compressor of the refrigerator (16), as a cold gas compressor (23) or as a pump that is operated at ambient temperatures and is integrated in the cooling circuit (11) by a counterflow heat exchanger (15).

11. Method according to any one of the preceding claims, **characterized in that** the cooling circuit (11) has a Joule-Thomson expansion stage (24).

## Revendications

1. Procédé de rééquipement d'un ensemble cryostat (1) qui présente une enceinte sous vide à température ambiante (10) dans laquelle est disposé un premier récipient (2) contenant un bain d'hélium liquide (3), dont la température de service est maintenue au-dessous de 5 K par évaporation d'hélium, dans laquelle enceinte sous vide à température ambiante (10) est en outre disposé un deuxième récipient (6) dans lequel conduisent des conduites d'agent de refroidissement, lequel est rempli d'azote liquide (7) pour l'isolation thermique du premier récipient (2) et peut être maintenu à une température de service de 75 à 80 K par évaporation d'azote, **caractérisé en ce**
**qu'**un milieu de refroidissement fluide (12), lequel est gazeux à une température de 60 K et une pression de 1 bar et présente un point d'ébullition sensiblement plus faible que l'azote, est introduit dans le deuxième récipient (6), et que le milieu de refroidissement (12) est refroidi à l'état gazeux à une température de service ≤ 60 K par un réfrigérateur (16) au moyen d'un circuit de refroidissement (11) dont les conduites d'agent de refroidissement conduisent dans le deuxième récipient (6).

2. Procédé selon la revendication 1, **caractérisé en ce que** de l'hélium ou du néon à l'état gazeux est utilisé comme milieu de refroidissement fluide (12).

3. Procédé selon la revendication 1 ou la revendication 2, **caractérisé en ce qu'**un échangeur de chaleur (19) est disposé dans le deuxième récipient (6) et raccordé aux conduites d'agent de refroidissement du circuit de refroidissement, et que le milieu de refroidissement (12) est refroidi à une température de service ≤ 60 K au moyen de l'échangeur de chaleur (19).

4. Procédé de rééquipement d'un ensemble cryostat (1) selon la revendication 1 ou la revendication 2, **caractérisé en ce que** les conduites d'agent de refroidissement du circuit de refroidissement (11) sont ouvertes à l'intérieur du deuxième récipient (6), de sorte que le milieu de refroidissement (12) est conduit du deuxième récipient (6) dans les conduites d'agent de refroidissement du circuit de refroidissement (11) et refroidi à une température de service ≤ 60 K.

5. Procédé selon l'une des revendications précédentes, **caractérisé en ce que** le deuxième récipient (6) est rempli, avant le rééquipement, d'azote liquide (7) qui, lors du rééquipement de l'ensemble cryostat (1), est complété ou remplacé par le milieu de refroidissement gazeux (12) introduit.

6. Procédé selon l'une des revendications précédentes, **caractérisé en ce qu'**en plus du milieu de refroidissement fluide (12), on laisse et/ou introduit dans le deuxième récipient (6) une quantité d'azote (22) qui occupe un volume d'au moins 5 1 à une température de service ≤ 60 K.

7. Procédé selon l'une des revendications précédentes, **caractérisé en ce que** l'ensemble cryostat fait partie d'un appareil pour la résonance magnétique nucléaire et sert à refroidir un ensemble d'aimants supraconducteurs (4).

8. Procédé selon l'une des revendications précédentes, **caractérisé en ce qu'**un élément d'amortissement (20) est intégré dans les conduites d'agent de refroidissement du circuit de refroidissement (11) pour l'isolation des vibrations mécaniques.

9. Procédé selon l'une des revendications précédentes, **caractérisé en ce que** l'ensemble cryostat présente un réservoir de milieu de refroidissement (21) disposé à l'extérieur de l'enceinte sous vide à température ambiante (10), au moyen duquel le deuxième récipient (6) et/ou le circuit de refroidissement (11) est alimenté en milieu de refroidissement (12) pour s'opposer aux fluctuations de pression.

10. Procédé selon l'une des revendications précédentes, **caractérisé en ce que** le circuit de refroidissement (11) présente un compresseur (13) qui est réalisé sous la forme d'un compresseur du réfrigérateur (16), d'un compresseur de gaz froid (23) ou d'une pompe fonctionnant à température ambiante qui est intégrée dans le circuit de refroidissement (11) par un échangeur de chaleur à contre-courant (15).

11. Procédé selon l'une des revendications précédentes, **caractérisé en ce que** le circuit de refroidissement (11) présente un étage de détente Joule-Thomson (24).
